Europäisches Patentamt

European Patent Office

Office européen des brevets

(11) Veröffentlichungsnummer: **0 085 332**
**A2**

(12) # EUROPÄISCHE PATENTANMELDUNG

(21) Anmeldenummer: 83100336.3

(22) Anmeldetag: 17.01.83

(51) Int. Cl.³: **H 01 L 21/288**
**H 01 L 21/445**

(30) Priorität: 27.01.82 DE 3202484

(43) Veröffentlichungstag der Anmeldung:
10.08.83 Patentblatt 83/32

(84) Benannte Vertragsstaaten:
CH DE FR GB IT LI LU

(71) Anmelder: BAYER AG
Zentralbereich Patente, Marken und Lizenzen
D-5090 Leverkusen 1, Bayerwerk(DE)

(72) Erfinder: Sirinyan, Kirkor, Dr.
Bamberger Strasse 16
D-5090 Leverkusen 1(DE)

(72) Erfinder: Merten, Rudolf, Dr.
Berta-von-Suttner-strasse 55
D-5090 Leverkusen 1(DE)

(72) Erfinder: Wolf, Gerhard Dieter, Dr.
Wilhelm-Busch-Strasse 29
D-4047 Dormagen 5(DE)

(72) Erfinder: Giesecke, Henning, Dr.
Düsseldorfer Strasse 49
D-5000 Köln 80(DE)

(72) Erfinder: Claussen, Uwe, Dr.
Carl-Rumpff-Strasse 29
D-5090 Leverkusen 1(DE)

(72) Erfinder: Ebneth, Harold, Dr.
Berta-von-Suttner-Strasse 61
D-5090 Leverkusen 1(DE)

(54) Metallisierte Halbleiter und Verfahren zu ihrer Herstellung.

(57) Die haftfeste Metallisierung, insbesondere partielle Metallisierung der Oberfläche von Halbleitern ohne Beizen gelingt, indem man die Aktivierung mit metallorganischen Verbindungen von Metallen der 1. und 8. Nebengruppe des Periodensystems der Elemente durchführt und anschließend in üblicher Weise reduziert und stromlos metallisiert.

EP 0 085 332 A2

BAYER AKTIENGESELLSCHAFT        5090 Leverkusen, Bayerwerk

Zentralbereich
Patente, Marken und Lizenzen   Jo/ABc

Metallisierte Halbleiter und Verfahren zu ihrer Herstellung

Unter Halbleitern versteht man Elemente, Verbindungen oder Legierungen, deren spezifischer elektrischer Widerstand zwischen dem der Metalle und dem der Isolatoren liegt, d.h., Werte zwischen etwa $10^{-4}$ und $10^{+12}$ $\Omega$ .cm hat.

Die heute üblichen Halbleiter bestehen aus Silizium, Germanium, Gallium und Arsen. Außerdem sind Verbindungshalbleiter, die mindestens aus zwei Elementen aufgebaut sind, mehrfach in der Literatur beschrieben, beispielsweise $A^{III} B^{V}$-Verbindungen, die aus Elementen der III. und V. Hauptgruppe oder $A^{II}B^{VI}$-Verbindungen, die aus Elementen der II. und VI. Hauptgruppe des Periodensystems der Elemente bestehen.

Halbleiter haben in jüngster Zeit für elektronische und elektrische Spezialbauelemente, wie Lumineszenzdioden, Hall-Sonden, Kondensatoren, Solarzellen, n-p-dotierte Transistoren, Feldeffekttransistoren, bipolar integrierte Transistoren, Thyristoren oder Informationsspeicher große technische Bedeutung erlangt.

Le A 21 503

Halbleiter, die als elektronische oder elektrische Elemente eingesetzt werden, müssen häufig mit einer elektrisch leitenden Schicht versehen werden. Das Aufbringen einer elektrisch leitenden oder ferromagnetischen Schicht kann · beispielsweise durch die Hochvakuum-Verdampfung mit Metallen oder durch das Vakuum-Sputtern mit Metalloxiden erzielt werden. Nachteile der Produkte der oben aufgeführten Verfahren sind schlechte Abriebbeständigkeiten, mangelnde Gleichmäßigkeit der elektrischen und magnetischen Eigenschaften, verursacht durch geringe Haftfestigkeit und Härte, sowie durch ungleichmäßige Schichtdicke der Metallschicht. Darüber hinaus sind die bisher bekannten Metallisierungsverfahren arbeitsintensiv und nicht in der Lage, die gewünschten feinen elektrischen Leiterbahnen, die einen komplizierten geometrischen Aufbau haben, bei der partiellen Metallisierung von elektrischen Halbleitern zu erzeugen. Der vorliegenden Erfindung liegt nun die Aufgabe zugrunde, Halbleiter mit einer haftfesten Metallschicht zu versehen, ohne ihre chemischen und physikalischen Eigenschaften zu ändern.

Diese Aufgabe wird dadurch gelöst, daß man gegebenenfalls mit Hilfe von entsprechenden Masken, Metalle auf der Oberfläche des elektrischen Halbleiters nach einem speziellen stromlosen, chemischen Verfahren abscheidet, wobei das abgeschiedene Metall anschließend noch galvanisch verstärkt werden kann.

Bei stromlosen chemischen Metallisierungsverfahren wird die Oberfläche des zu metallisierenden Substrates zu-

Le A 21 503

nächst aktiviert, wozu man Elemente der 1. und 8. Nebengruppe des Periodensystems der Elemente verwendet, beispielsweise Silber, Kupfer, Gold, Platin und vorzugsweise Palladium, die man als Salzlösung (ionisches Verfahren) oder als Sol (kolloidales Verfahren) eingesetzt. Der Aktivierung folgt die Reduktion der Edelmetallionen, sofern solche noch vorhanden sind, woran sich die Metallisierung in einem Metallisierungsbad, beispielsweise einem Nickelbad, anschließt. Diesen Verfahren hat, damit nach Aktivierung und Metallisierung die Metallschicht auf der Substratoberfläche gut haftet, stets ein Beizen der Substratoberfläche voranzugehen, z.B. mit Chromschwefelsäure oder anderen Oxidantien. Ein solches Beizverfahren kann bei Halbleitern wegen der irreversiblen Änderung wichtiger Eigenschaften, beispielsweise der Kriechstromfestigkeit des elektrischen Oberflächenwiderstandes, der Lichtabsorption und der Lichtdurchlässigkeit keine Verwendung finden.

Es wurde nun gefunden, daß die Metallisierung von Oberflächen von Halbleitern ohne Beizen gelingt, wenn man die Aktivierung mit metallorganischen Verbindungen von Metallen der 1. und 8. Nebengruppe des Periodensystems der Elemente durchführt. Im Anschluß an die Aktivierung folgt dann die Reduktion der metallorganischen Verbindungen zum Metall und die Metallisierung, beispielsweise Vernickelung mit einem üblichen Metallisierungsbad.

Gegenstand der Erfindung sind daher auf der Oberfläche metallisierte Halbleiter, dadurch gekennzeichnet, daß die

Le A 21 503

Metallschicht ohne vorheriges Beizen durch Aktivierung mit metallorganischen Verbindungen von Metallen der 1. und 8. Nebengruppe des Periodensystems der Elemente, Reduktion und stromlose naßchemische Metallisierung aufgebracht wird.

Ein weiterer Gegenstand der Erfindung ist ein Verfahren zur Herstellung von auf der Oberfläche metallisierten Halbleitern, dadurch gekennzeichnet, daß auf die Halbleiter-Oberfläche ohne vorheriges Beizen metallorganische Verbindungen von Elementen der 1. und 8. Nebengruppe des Periodensystems der Elemente aufgebracht, die metallorganischen Verbindungen reduziert und die Halbleiteroberfläche einem Metallisierungsbad der stromlosen Metallisierung ausgesetzt wird.

Mit dem Verfahren können Halbleiteroberflächen, insbesondere partiell metallisiert werden, beispielsweise in Form von Leiterbahnen.

Das Verfahren eignet sich insbesondere für die Metallisierung von fotovoltaische Elementen.

Fotovoltaische Elemente, z.B. Solarzellen, sind in der Lage, Sonnenlicht direkt in elektrische Energie umzuwandeln. In ihnen entsteht bei der Bestrahlung mit Licht ein internes elektrisches Feld, in dem die gleichzeitig entstehenden positiven und negativen Ladungsträger räumlich voneinander getrennt sind. Um den fotoelektrischen Strom zu nutzen, ist es erforderlich, die getrennten

Le A 21 503

Ladungsträger über geeignete Kontakte und elektrische Leiterbahnen zu einem Verbrauchswiderstand abzuleiten. Von diesen Kontakten, die als Linienmuster auf der der Strahlung zugewandten Seite der fotovoltaischen Zelle aufgebracht werden, wird verlangt, daß sie bei möglichst geringer Bedeckung der Oberfläche des fotovoltaischen Elementes möglichst alle entstehenden Ladungsträger ableiten. Dies gelingt erfindungsgemäß in weitaus höherem Maße als mit bisherigen Verfahren, weil es bisher nicht möglich war, extrem feine Kontakte mit genügender Leitfähigkeit auf die Oberfläche der fotovoltaischen Zelle aufzubringen.

Besonders geeignete fotovoltaische Elemente sind Halbleiter auf Basis von Galliumarsenid.

Bevorzugte Möglichkeiten für das Aufbringen der Aktivatoren auf die Halbleiteroberfläche sind Bedrucken, Besprühen, Bestempeln oder Tauchbeschichten. Natürlich kann die zu metallisierende Halbleiteroberfläche mit einer Schablone versehen, erfindungsgemäß in einem Aktivierungsbad aktiviert, in einem üblichen chemischen Metallisierungsbad metallisiert und von der Schablone auf chemischem oder physikalischem Wege befreit werden.

Die für die Metallbindung der metallorganischen Verbindungen erforderlichen Gruppen des organischen Teiles ·der metallorganischen Verbindung sind an sich bekannt. Es handelt sich zum Beispiel um C-C- oder C-N-Doppel- und Dreifachbindungen und um Gruppen, die einen Chelat-Komplex ausbilden können, z.B. -OH-, -SH-, -CO-, -CS- oder -COOH-Gruppen.

Le A 21 503

Neben monomeren metallorganischen Verbindungen eignen sich insbesondere auch oligomere, polymere und präpolymere $\pi$- und/oder Chelat-Verbindungen der Elemente der 1. und 8. Nebengruppe des Periodensystems, die beispielsweise unter Elektronen-, $\gamma$-, Lichtbestrahlung oder Erwärmung zur Bildung eines Films befähigt sind. Nach der Trocknung des dünnen Filmes auf der Halbleiteroberfläche werden die metallorganischen Verbindungen durch Reduktionsmittel, z.B. die des chemischen Metallisierungsbades, in freies Metall überführt. Diese Metallpartikel ermöglichen eine reduktive Metallabscheidung im chemischen Metallisierungsbad. Hierbei ist eine zusätzliche Behandlung der Aktivierungsschicht im $Sn^{2+}$-Bad zur Sensibilisierung des Katalysators nicht erforderlich, was das chemische Metallisierungsverfahren auf zwei Schritte reduziert, nämlich das Aufbringen des Aktivierungsfilms auf die Halbleiter-Oberfläche und die chemische Metallisierung der Substratoberfläche, mit dem Reduktionsmittel enthaltenden Metallisierungsbad.

So können beispielsweise mit 4-Cyclohexen-1,2-carbonsäureanhydrid-palladiumdichlorid versetzte Resite oder Melaminharzvorprodukte als dünne Beschichtung auf Substratoberflächen beispielsweise durch Bedrucken oder Bestempeln aufgebracht, ausgehärtet und in chemischen Metallisierungsbädern partiell metallisiert werden.

Le A 21 503

Um eine gute Haftung bzw. Kontaktierung zu erzeugen, tragen die metallorganischen Verbindungen über die zur Metallbindung erforderlichen Gruppen hinaus vorzugsweise eine weiter funktionelle Gruppe.

Besonders geeignet für eine chemische Verankerung des Aktivators an der Halbleiter-Oberfläche sind funktionelle Gruppen wie Carbonsäuregruppen, Carbonsäurehalogenidgruppen, Carbonsäureanhydridgruppen, Carbonestergruppen, Carbonamid- und Carbonimidgruppen, Aldehyd- und Ketongruppen, Ethergruppen, Sulfonamidgruppen, Sulfonsäuregruppen und Sulfonatgruppen, Sulfonsäurehalogenidgruppen, Sulfonsäureestergruppen, halogenhaltige heterocyclische Reste, wie Chlortriazinyl-, -pyrazinyl-, -pyrimidinyl- oder -chinoxalinylgruppen, aktivierte Doppelbindungen, wie bei Vinylsulfonsäure- oder Acrylsäurederivaten, Aminogruppen, Hydroxylgruppen, Isocyanatgruppen, Olefingruppen und Acetylengruppen sowie Mercaptogruppen und Epoxidgruppen, ferner höherkettige Alkyl- oder Alkenylreste ab $C_8$, insbesondere Olefin-, Linolein-, Stearin- oder Palmitingruppen.

Wenn keine Verankerung durch eine chemische Reaktion stattfindet, kann die Haftfestigkeit auch durch Absorption der organometallischen Aktivatoren an der Halbleiter-Oberfläche bewirkt werden, wobei als Ursachen für die Absorption z.B. Wasserstoffbrückenbindungen oder van der Waalssche-Kräfte in Frage kommen.

Le A 21 503

Besonders geeignet für eine Verankerung des Aktivators an der Halbleiter-Oberfläche durch Adsorption sind funktionelle Gruppen wie Carbonsäuregruppen, Carbonsäureanhydridgruppen.

Es ist zweckmäßig, die die Adsorption hervorrufenden funktionellen Gruppen auf den jeweiligen Halbleiter abzustimmen.

Ganz besonders bevorzugt wird mit metallorganischen monomeren, oligomeren, polymeren u. präpolymeren Verbindungen der Elemente Pd, Pt, Au, Ag gearbeitet, da diese Elemente eine starke katalytische Wirkung besitzen und unter den angewandten Reaktionsbedingungen keine chemischen und physikalischen Veränderungen an den Halbleitern erzeugen.

Selbstverständlich können auch Mischungen dieser Verbindungen zur Aktivierung von Halbleitern eingesetzt werden. Die metallorganischen Verbindungen werden insbesondere in Form einer Lösung oder Suspension in einem organischen Lösungsmittel eingesetzt. Dabei soll die Konzentration an metallorganischer Verbindung zwischen 0,01 g und 15 g pro Liter betragen, kann aber in besonderen Fällen auch darunter oder darüber liegen. Als organische Lösungsmittel sind besonders polare, protische und aprotische Lösungsmittel wie Methylenchlorid, Chloroform, 1,1,1-Trichlorethan, Trichlorethylen, Perchlorethylen,

- 9 -

Aceton, Methylethylketon, Butanol, Ethylenglykol und Tetrahydrofuran geeignet.

Selbstverständlich können auch Gemische obiger Lösungsmittel und Verschnitte mit anderen Lösungsmitteln, wie Benzin, Ligroin, Toluol, usw. verwendet werden.

Bevorzugt werden Lösungen eingesetzt.

Mit diesen Lösungen werden bei dem erfindungsgemäßen Verfahren die Oberfläche der zu metallisierenden Halbleiter benetzt, wobei die Einwirkungsdauer vorzugsweise 1 Sekunde bis 85 Minuten beträgt. Nach der Benetzung wird das organische Lösungsmittel entfernt.

Die so aktivierten Oberflächen können direkt zur stromlosen Metallisierung eingesetzt werden.

Ohne den Umfang des erfindungsgemäßen Verfahrens einzuschränken, empfiehlt es sich, bei der Durchführung des Verfahrens folgende Parameter einzuhalten:

- Die Aktivatoren zur chemischen Metallisierung sollen in gängigen Lösemitteln wie z.B. Methanol, Ethanol, n-Butanol, Methylethylketon, Toluol, n-Hexan, löslich sein oder Suspension bilden.

- Die Lösungsmittel müssen leicht entfernbar sein und dürfen nicht zu einem chemischen Abbau der metallorganischen Verbindungen führen.

Le A 21 503

- Die zur chemischen Metallisierung geeigneten Aktivatoren dürfen nicht zu einer Vergiftung des chemischen Metallisierungsbades führen.

- Die zu metallisierenden Halbleiter dürfen die chemische Metallisierungsbäder nicht vergiften.

- Die metallorganischen Verbindungen dürfen nicht in die Halbleiter diffundieren.

- Die an der Halbleiter-Oberfläche fixierten Aktivatoren dürfen nicht elektrisch isolierend wirken.

- Um die Haftung der reduktiv abgeschiedenen Metallschicht an der Halbleiteroberfläche zu erhöhen, kann eine Temperung des Probekörpers, gegebenenfalls bei erhöhtem Druck durchgeführt werden.

- Um eine optimale Kontaktierung zu erzielen, soll die Schichtdicke des reduktiv abgeschiedenen Metalls von etwa 0,01 µm bis etwa 3,0 µm betragen.

- Die Aktivierung der Halbleiter zur chemischen Metallisierung kann bei Temperaturen von etwa -80°C bis etwa +120°C durchgeführt werden, wobei die Temperaturen von etwa +10°C bis etwa +40°C besonders bevorzugt sind.

Le A 21 503

Beispiel 1

Ein 2 x 2 cm großes Quadrat eines fotovoltaischen Elementes auf der Basis von n- und p-dotiertem Silizium wird bei Raumtemperatur im Verlaufe von 30 Sekunden in einem Aktivierungsbad aus 1,4 g Isobutylvinyletherpalladiumdichlorid in 1 l 1,1,1-Trichlorethan aktiviert. Die den Lichtstrahlen zugängliche Oberfläche wird mit einer Maske, welche freie kammförmige Bahnen von etwa 2 μm Breite aufweist, bedeckt und mit einer 10 gew.-%igen Styrolbutadiencopolymerisat-Lösung in Methylenchorid, bestempelt. Nach der Trocknung der Lackschicht wird die so aktivierte Platte bei Raumtemperatur 15 Minuten in einem wäßrigen Vernickelungsbad, das in 1 l 3,5 g Dimethylaminoboran, 30 g Nickelchlorid und 10 g Citronensäure enthält und mit konz. Ammoniaklösung auf pH 8,2 eingestellt ist, stromlos vernickelt.

Nach etwa 2 Minuten färben sich die freien Bahnen dunkel und nach ca. 6 Minuten wird eine metallisch glänzende Schicht beobachtet. Nun wird die Schablone mit Methylethylketon gelöst, das Lösungsmittel verdampft, die Halbleiteroberfläche mit einer 10 gew.-%igen toluolischen Polycarbonatlösung durch Tauchen benetzt und das Toluol unter Vakuum verdampft.

Man bekommt eine fotovoltaische Zelle mit 2 μm breiten und 0,2 μm starken Leiterbahnen. Die Metallschicht haftet an der Substratoberfläche so gut, daß sie mit einem Tesa-Film der Fa. Beiersdorf AG, Hamburg, nicht von der Substratoberfläche zu entfernen ist.

Le A 21 503

Beispiel 2

Eine runde Scheibe vom Durchmesser 5 cm eines im Beispiel 1 aufgeführten n- und p-dotierten fotovoltaischen Elementes wird mit einer Schablone, welche kamm- und rechteckförmige 0,8 µm breite freie Stellen aufweist, bedeckt und mit einer 10 gew.-%igen Lösung von Styrolbutadiencopolymerisat in Methylenchlorid bedruckt. Nach der Aushärtung wird die Scheibe in eine Aktivierungslösung aus 1,85 g 9-Octadecen-1-olpalladiumdichlorid in 1 l Methanol getaucht und dann in einem chemischen Nickelbad gemäß Beispiel 1 vernickelt. Darauf wird dem Probekörper mit Methylenchlorid die Maske entfernt.

Man bekommt ein fotovoltaisches Element mit elektrisch leitenden Bahnen von 0,8µm Breite und 0,2µm Stärke.

Beispiel 3

Eine n- und p-dotierte Cu/CuGaSe$_2$-Zelle mit fotovoltaischem Effekt wird auf der CuGaSe$_2$-Schicht gemäß Beispiel 1 mit einer methanolunlöslichen Maske versehen, so daß die Zelle freie durchgehende halbkreis-, dreieck-, kamm- und rechteckförmige Bahnen aufweist. Nach der Trocknung der Maske und Aktivierung gemäß Beispiel 1 wird die Zelle in einem wäßrigen Verkupferungsbad, das in 1 l 10 g CuSO$_4$, 15 g Seignette-Salz, 20 ml 35 gew.-%ige Formalinlösung enthält und mit 32 gew.-%iger NaOH-Lösung auf pH 12 bis 13 eingestellt ist, bei 35°C stromlos verkupfert. Man bekommt ein mit 2 µm breiten elektrisch leitenden Bahnen versehenes fotovoltaisches Element.

Le A 21 503

Beispiel 4

Eine runde fotovoltaische Zelle mit einem Durchmesser von 2,5 cm aus einer metallischen Trägerplatte und zweischichtigem n-/p-dotiertem Galliumarsenid wird mit der den Sonnenstrahlen zugänglichen Seite mit einer palladierten dienhaltigen 12 gew.-%igen methylethylketonischen oligomeren Polyesterlösung in Form von 50μm breiten Leiterbahnen bedruckt. Nach der Trocknung der Aktivierungsschicht wird die Zelle nach Beispiel 1 in einem chemischen Vernickelungsbad im Verlaufe von 20 Minuten mit ∼ 50μm breiten und ∼ 0,23μm starken Ni-Bahnen versehen.

Man erhält ein durchgehend kontaktiertes fotovoltaisches Element. Der elektrische Widerstand der Leiterbahnen ist so gering, daß sie in einem üblichen wäßrigen galvanischen Verkupferungsbad, welches pro 1 200 g $CuSO_4 \cdot 5H_2O$ und 30 g $H_2SO_4$ ($\rho$ = 1,84 $g/cm^3$) enthält, als Kathode geschaltet bei 0,1 Ampére mit galvanischem Kupfer auf ca. 4μm verstärkt werden.

Das palladierte Oligomere wird wie folgt erhalten:

12 g dienhaltiger Polyester mit 42 Gew.-% ungesättigten Fettsäuren und der Molmasse $\overline{M}_n$ = 780 werden durch Ligandenaustausch mit 1,0 g Acetonitrilpalladiumdichlorid in 150 ml Dimethylformamid bei ∼ 40°C im Verlaufe von 80 Minuten versetzt und anschließend dann das Acetonitril und Dimethylformamid bei 40°C und unter Hochvakuum dem Polymerisat entzogen.

Beispiel 5

Die im Beispiel 4 aufgeführte Zelle wird nach Beispiel 1 mit einer Maske versehen, aktiviert, im Verlaufe von 2 Minuten vernickelt und anschließend in einem üblichen chemischen Vergoldungsbad vergoldet.

Man bekommt ein partiell vergoldetes fotovoltaisches Element mit elektrisch leitenden Bahnen, die gegen die üblichen Oxidantien inert sind.

Beispiel 6

Eine 4 x 2,5 cm große n- und p-dotierte Halbleiterzelle aus $Cu_2S/CdS$ wird mit einer Lösung aus 18 g palladiertem Polybutadien mit der Molmasse Mn = 900 und 5,2 Gew.-% Palladium (bezogen auf trockene Polymermasse) in 1 l Methylenchlorid in Form von 3,5μm breiten durchgehenden kammförmigen Bahnen bedruckt, vom Lösungsmittel im Vakuum befreit und gemäß Beispiel 1 vernickelt. Man bekommt eine mit elektrisch leitenden Bahnen versehene Solarzelle. Diese Leiterbahnen haben eine Breite von ca. 3,5μm und Stärke von ca. 0,2μm.

Beispiel 7

Eine n- und p-dotierte 5 x 5 cm große Siliziumzelle mit fotovoltaischem Effekt wird mit einer durchsichtigen, elektrisch leitenden $4,6 \cdot 10^3$ Å starken, $In_2O_3/SnO_2$-Schicht mit einem Widerstand von 21/0 $\Omega$ pro Quadrat versehen, nach Beispiel 1 aktiviert, mit einer

Le A 21 503

Maske versehen, metallisiert und von der Schablone auf der Oberfläche befreit. Man erhält eine Solarzelle mit elektrisch leitenden Bahnen.

## Beispiel 8

Die im Beispiel 1 beschriebene Zelle wird mit einem UV-härtbaren Lack auf der Basis von oligomerem 1,4-Polyisopren (∼15 gew.-%ig in Xylol) mit lichtempfindlichem Diazol-Initiator besprüht, die Lackschicht mit einer Maske bedeckt und mit Hilfe einer UV-Bestrahlung ausgehärtet. Der nicht ausgehärtete Lackanteil wird nach Entfernen der Maske vom Probekörper entfernt. Nach der Trocknung wird die so mit 70µm breiten freien Bahnen versehene Probe nach Beispiel 1 aktiviert und metallisiert.

Man erhält eine mit 0,2µm starken und 70µm breiten elektrisch leitenden Bahnen versehene Solarzelle.

## Beispiel 9

Ein 2 x 2 mm großes Quadrat einer alternierden, n-p-n-p-dotierten, 0,1 mm starken Siliziumplatte wird mit dem im Beispiel 1 angegebenen Aktivierungsbad im Verlaufe von 30 Sekunden aktiviert, die Plattenränder mit einer 10 gew.-%igen Polycarbonatlösung in Methylenchlorid versehen, nach dem Verdampfen des Methylenchlorids in einem chemischen Vernickelungsbad, welches Dimethylaminoboran als Reduktionsmittel enthält, im Verlaufe

Le A 21 503

von 15 Minuten metallisiert.

Die so abgeschiedene 0,1μm starke Ni-Schicht wird in einem galvanischen Vergoldungsbad bei 0,5 Amp/dm$^2$ auf 15μm verstärkt.

Man bekommt ein Metall-Halbleiter-Metall-Verbundmaterial, welches als Thyristor eingesetzt werden kann.

Beispiel 10

Eine runde 0,4 mm starke Scheibe mit dem Durchmesser 18 mm eines n-Typ-Halbleiters auf der Basis von Germanium wird in einem Aktivierungsbad, welches aus 0,5 g 4-Cyclohexen-1,2-dicarbonsäureanhydridpalladiumdichlorid und 1 l $CH_2Cl_2$ besteht, im Verlaufe von 20 Sekunden aktiviert und dann nach Beispiel 1 im Verlaufe von 8 Minuten mit einer 0,18μm starken Ni-Schicht versehen.

Beispiel 11

Eine 4 x 4 x 0,1 mm große Platte eines n-p-dotierten Halbleiters auf der Basis von Silizium, welche auf einer $SiO_2$-Platte fixiert ist, wird mit einer Schablone beidseitig gemäß Beispiel 1 bedruckt, nach der Trocknung gemäß Beispiel 1 auf chemischem Wege vernickelt und dann von der Maske befreit.

Man bekommt ein Nichtleiter-Halbleiter-Verbundmaterial mit elektrisch leitenden Bahnen von 0,8μm Breite und 0,2μm Stärke.

Le A 21 503

Beispiel 12

Eine 1,2 x 1,0 x 0,2 mm starke p-Halbleiterplatte auf der Basis von Silizium wird einseitig mit dem in Beispiel 6 angegebenen Aktivator in Form von 30µm breiten und durchgehenden Bahnen bedeckt, nach der Trocknung gemäß Beispiel 1 vernickelt und die nickelfreie Seite mit einer 5µm starken $SiO_2$-Schicht versehen.

Man bekommt einen elektronischen Baustein aus Metall-Halbleiter-Isolator.

Patentansprüche

1) Auf der Oberfläche metallisierte Halbleiter, dadurch gekennzeichnet, daß die Metallschicht ohne vorheriges Beizen durch Aktivierung mit metallorganischen Verbindungen von Metallen der 1. und 8. Nebengruppe des Periodensystems der Elemente, Reduktion und stromlose naßchemische Metallisierung aufgebracht wird.

2) Metallisierte Halbleiter nach Anspruch 1, dadurch gekennzeichnet, daß die Halbleiter aus Silizium, Germanium, Gallium, Arsen, $A^{III}-B^{V}-$ oder $A^{II}B^{VI}-$Verbindungen bestehen.

3) Metallisierte Halbleiter nach Anspruch 1, dadurch gekennzeichnet, daß es fotovoltaische Elemente auf der Basis Galliumarsenid sind.

4) Verfahren zur Herstellung von auf der Oberfläche metallisierten Halbleitern, dadurch gekennzeichnet, daß auf die Halbleiter-Oberfläche ohne vorheriges Beizen metallorgaische Verbindungen von Elementen der 1. und 8. Nebengruppe des Periodensystems der Elemente aufgebracht, die metallorganischen Verbindungen reduziert und die Halbleiteroberfläche einem Metallisierungsbad der stromlosen Metallisierung ausgesetzt wird.

5) Verfahren nach Anspruch 3, dadurch gekennzeichnet, daß die Oberfläche partiell metallisiert wird.

Le A 21 503